# EUROPÄISCHE PATENTSCHRIFT

(11) **EP 3 690 575 B1**
(45) Veröffentlichungstag und Bekanntmachung des Hinweises auf die Patenterteilung: **24.08.2022**
(21) Anmeldenummer: 19155284.3
(22) Anmeldetag: 04.02.2019
(51) Int. Cl.: G05B 19/418

(54) **VERFAHREN ZUR ÜBERPRÜFUNG EINER KONSISTENTEN ERFASSUNG VON ROHRLEITUNGEN IN EINEM PROJEKTIERUNGSSYSTEM, PROJEKTIERUNGSSYSTEM UND STEUERUNGSPROGRAMM**
PLANNING SYSTEM, METHOD FOR TESTING A CONSISTENT DETECTION OF PIPES IN A PLANNING SYSTEM, AND CONTROL PROGRAM
PROCÉDÉ DE VÉRIFICATION D'UNE DÉTECTION CONSTANTE DE TUYAUTERIE DANS UN SYSTÈME DE PLANIFICATION, SYSTÈME DE PLANIFICATION ET PROGRAMME DE COMMANDE

(43) Veröffentlichungstag der Anmeldung: 05.08.2020
(73) Patentinhaber: Siemens Aktiengesellschaft, 80333 München (DE)
(72) Erfinder: Rommelfanger, Rainer, 54290 Trier (DE)

(56) Entgegenhaltungen:
- EP-A1- 2 587 329
- US-A1- 2006 247 902

## Beschreibung

Industrielle Automatisierungssysteme dienen zur Überwachung, Steuerung und Regelung von technischen Prozessen, insbesondere im Bereich Fertigungs-, Prozess- und Gebäudeautomatisierung, und ermöglichen einen im wesentlichen selbständigen Betrieb von Steuerungseinrichtungen, Sensoren, Maschinen und technischen Anlagen. Eine wesentliche Grundlage für eine zuverlässige Bereitstellung von Überwachungs-, Steuerungs- und Regelungsfunktionen mittels eines Prozessautomatisierungssystems besteht in einer vollständigen und korrekten Erfassung und Abbildung von Komponenten des industriellen Prozessautomatisierungssystems in einem Engineerung- bzw. Projektierungssystem.

Mittels eines Engineering-Systems können insbesondere Steuerungsprogramme für Automatisierungsgeräte projektiert werden, die zur Visualisierung eines Abbilds einer technischen Anlage oder einer komplexen Maschine und deren Steuerung bzw. Regelung vorgesehen sind. Zur Laufzeit der Steuerungsprogramme bzw. während eines Runtime-Betriebs wird ein technischer Prozess durch Automatisierungsgeräte, wie speicherprogrammierbare Steuerungen, gesteuert bzw. geregelt. Im Rahmen einer Prozessüberwachung während des Runtime-Betriebs kann eine Bedienperson Prozessbilder aufrufen, um einen Überblick über einen aktuellen Anlagenzustand zu erhalten sowie eine Prozessführung bzw. -bedienung wahrzunehmen.

In EP 1 166 215 B1 ist ein Verfahren zur automatischen Wiedergewinnung von Engineering-Daten aus technischen Anlagen beschrieben, bei dem Engineering- und Runtime-Objekte durch ein einheitliches Objektmodell beschrieben werden. Dadurch lässt sich eine direkte Entsprechung zwischen Engineering-Objekten und Runtime-Objekten auf Objektebene festlegen, so dass kein Informationsverlust durch eine Abbildung von Anlagenkomponenten auf das Objektmodell entsteht. Außerdem kann eine direkte Kommunikation zwischen Engineering- und Runtime-Objekten erfolgen.

Aus EP 2 808 749 B1 ist ein Verfahren zum Austausch von Steuerungsinformationen zwischen Bedien- und Beobachtungsgeräten eines industriellen Automatisierungssystems bekannt. Anhand der Steuerungsinformationen wird ein zumindest ausschnittweises Abbild einer mittels Automatisierungsgeräten geregelten oder gesteuerten technischen Anlage an einer graphischen Benutzerschnittstelle eines jeweiligen Bedien- und Beobachtungsgeräts visualisiert. Dem visualisierten Abbild sind Elemente der technischen Anlage repräsentierende computerbasierte Objekte zugeordnet, die durch eine auf einem jeweiligen Bedien- und Beobachtungsgerät eingerichtete Laufzeitumgebung bereitgestellt werden. Sämtliche an unterschiedlichen Bedien- und Beobachtungsgeräten bereitgestellten Objekttypen werden entsprechend einem einheitlichen Adressierungsschema für einen geräteübergreifenden Zugriff verfügbar gemacht.

US 6 063 128 betrifft ein System, das ein Speichergerät, eine erste und zweite Hardware- oder Software-Plattform, ein persistentes portables Datenmodell und computerbasierte Modellbildungssysteme umfasst, die von der ersten und zweiten Plattform abhängig sind. Jede Plattform weist eine Schnittstelle zum Speichergerät auf und stellt systemabhängige Dienste bereit. Der ersten Plattform sind ein erster Betriebssystem-Typ sowie ein erster Computer-Hardware-Typ zugeordnet, während der zweiten Plattform ein zweiter Betriebssystem-Typ sowie ein zweiter Computer-Hardware-Typ zugeordnet sind. Das portable Datenmodell ist im Speichergerät in einem plattformunabhängigen Format gespeichert und umfasst persistente Komponenten-Objekte. Darüber hinaus ist das computerbasierte Modellbildungssystem für die erste Plattform in einem ersten Speicherbereich des Speichergeräts gespeichert, während das computerbasierte Modellbildungssystem für die zweite Plattform in einem zweiten Speicherbereich des Speichergeräts gespeichert ist. Jedes computerbasierte Modellbildungssystem stellt Dienste bereit, um das portable Datenmodell aus dem Speichergerät abzurufen, das Datenmodell durch Hinzufügen und Entfernen von Komponenten-Objekten zu ändern und das Datenmodell persistent im Speichergerät zu speichern. Außerdem umfasst jedes computerbasierte Modellbildungssystem einen statischen Kernel und ein dynamisches Software-Framework. Die Kernel laufen auf der jeweiligen Plattform ab und bilden Schnittstellen zum zugeordneten Betriebssystem und zur entsprechenden Computer-Hardware. Die Software-Frameworks laufen auf der jeweiligen Plattform ab, bilden Schnittstellen zum zugeordneten Kernel und stellen jeweils eine plattformunabhängige graphische Benutzerschnittstelle bereit.

In WO 2010/037145 A2 ist ein Verfahren zum Verwalten einer Prozesssteuerung in einem Computersystem, das zur Konfigurierung und Überwachung einer Prozessanlage vorgesehen ist. Das Computersystem stellt eine interaktive Benutzerschnittstelle zum Verwalten einer Mehrzahl von Objekten in der Prozessanlage bereit. Dabei entspricht jedes Objekt der Mehrzahl von Objekten einer physischen oder logischen Einheit in der Prozessanlage. Außerdem wird ein Navigationsbereich zum Anzeigen eines Satzes von auswählbaren Elementen erstellt. Jedes Element in dem Satz von auswählbaren Elementen entspricht einem jeweiligen Objekt aus der Mehrzahl von Objekten. Des weiteren wird ein Befehlsbereich zum Darstellen eines Satzes von auswählbaren Steuerungselementen erstellt. Jedes Steuerungselement aus dem Satz von auswählbaren Steuerungselementen entspricht einer Aufgabe, die an wenigstens einem Objekt der Mehrzahl von Objekten in der Prozessanlage durchgeführt werden soll. Über den Navigationsbereich wird eine Auswahl eines Elements aus dem Satz von auswählbaren Elementen empfangen, während über den Befehlsbereich eine Auswahl eines Steuerungselements aus dem Satz von auswählbaren Steuerungselementen empfangen wird. Anhand der erhaltenen Auswahl wird ein Betriebskontext bestimmt. Der Betriebskontext entspricht einem Satz von Aktionen, die auf die Auswahl anwendbar sind, wenn die Auswahl eine Elementauswahl ist, oder einem Satz von Elementen, auf welche die Auswahl anwendbar ist, wenn die Auswahl eine Steuerungselementauswahl ist. Der Navigationsbereich oder der Befehlsbereich werden entsprechend dem Betriebskontext angepasst.

Aus EP 3 364 257 A1 ist ein Engineering-System für ein industrielles Prozessautomatisierungssystem bekannt, bei dem Komponenten des industriellen Prozessautomatisierungssystems jeweils durch ein computerbasiertes Objekt repräsentiert und in zumindest einer Server-seitigen Datenbank persistent gespeichert werden. Durch eine Benutzerselektion vorgegebene Objekte werden für eine Bearbeitung aus der Datenbank in zumindest einen Bearbeitungsspeicherbereich geladen. Bei Einleitung einer Benutzerfreigabe von in einen ausgewählten Bearbeitungsspeicherbereich geladenen freizugebenden Objekten wird überprüft, ob ein direkt vorrangiger Bearbeitungsspeicherbereich vorhanden ist. Für in den ausgewählten Bearbeitungsspeicherbereich geladene freigebbare Objekte werden bei einem positiven Überprüfungsergebnis direkte Vorgänger im vorrangigen Bearbeitungsspeicherbereich ermittelt und zu den freigebbaren Objekten hinzugefügt. Unter den freigebbaren Objekten werden zu freizugebenden Objekten hierarchisch untergeordnete Objekte ermittelt und zur Freigabe gekennzeichnet. Die zur Freigabe gekennzeichneten Objekte werden durch Änderung ihrer Zuordnung aus dem ausgewählten Benutzerspeicherbereich in den vorrangigen Benutzerspeicherbereich verschoben.

Aus US 2006/247902 A1 ist ein 3D-CAD-Verfahren zur Verlegung von Rohren, Kanälen, Versorgungsleitungen und HLK-Leitungen (Heizung, Lüftung und Kühlung) bekannt. Dabei werden eine Router-Software für 2D-Echtzeitanwendungen und eine grafische Benutzerschnittstelle kombiniert, um eine Bearbeitungsumgebung zu schaffen, in der ein Konstrukteur schnell vollständig gültige 3D-Routen für Rohrleitungen, HLK-Leitungen, Seilbahnen und andere geschwungene dreidimensionale Körper erstellen kann.

Rohrleitungen werden bei ihrer Konstruktion mittels eines Projektierungssystems zunächst schematisch und zweidimensional in einem Rohrleitungs- und Instrumentenfließschema (Piping and Instrumentation Diagram, P&ID) erzeugt. Danach wird eine dreidimensionale Konstruktion der Rohrleitung erstellt. Komponenten und Abzweige müssen sowohl in zweidimensionaler als auch in dreidimensionaler Darstellung vorhanden sein und hinsichtlich ihrer Reihenfolge übereinstimmen. Außerdem müssen die Rohrleitungen in beiden Darstellungsarten in Bezug auf ihre Verbindungen bzw. Anschlüssen zu externen Geräten oder Rohrleitungen übereinstimmen.

Der vorliegenden Erfindung liegt die Aufgabe zugrunde, ein Verfahren zur zuverlässigen und schnellen Überprüfung einer konsistenten zweidimensionalen und dreidimensionalen Erfassung von Rohrleitungen in einem Projektierungssystem zu schaffen und geeignete Mittel zur Implementierung des Verfahrens anzugeben.

Diese Aufgabe wird erfindungsgemäß durch ein Verfahren mit den in Anspruch 1 angegebenen Merkmalen, durch ein Projektierungssystem mit den in Anspruch 12 angegebenen Merkmalen und durch ein Steuerungsprogramm mit den in Anspruch 13 angegebenen Merkmalen gelöst.

Entsprechend dem erfindungsgemäßen Verfahren zur Überprüfung einer konsistenten Erfassung von Rohrleitungen in einem Projektierungssystem, bei dem Rohrleitungen in einem ersten Plan zweidimensional und in einem zweiten Plan dreidimensional erfasst sind, wird für in beiden Plänen erfasste Rohrleitungen jeweils zumindest ein Hauptpfad innerhalb des jeweiligen Plans ermittelt. Vorzugsweise wird der Hauptpfad als Pfad ermittelt, der keinen anderen Pfad innerhalb der jeweiligen Rohrleitung als Abzweigung bzw. Anschluss des anderen Pfades in Nebenfluss-Richtung trifft. Dabei weist jede Abzweigung genau einen eingehenden Anschluss in Hauptfluss-Richtung, genau einen ausgehenden Anschluss in Hauptfluss-Richtung und zumindest einen eingehenden oder ausgehenden Anschluss in Nebenfluss-Richtung auf. Grundsätzlich kann der Hauptpfad durch Eliminierung zu Maschen bzw. parallelen Zweigen innerhalb einer Rohrleitung führender Pfade ermittelt werden.

Für die erfassten Hauptpfade werden erfindungsgemäß innerhalb beider Pläne jeweils miteinander zu vergleichende Sequenzen von Leitungskomponenten, Abzweigen bzw. Anschlüssen umfassenden Objekten ermittelt. Aus den zu vergleichenden Sequenzen werden jeweils Objekte ohne gegenseitige Entsprechung eliminiert, die nur in einem der beiden Pläne bzw. nur in einem Hauptpfad eines der beiden Pläne erfasst sind. Nach Eliminierung der Objekte ohne gegenseitige Entsprechung werden innerhalb der zu vergleichenden Sequenzen iterativ Objekte mit unterschiedlicher Reihenfolge ermittelt und klassifiziert, die hinsichtlich ihrer Reihenfolge innerhalb der zu vergleichenden Sequenzen eine maximale Reihenfolgedifferenz aufweisen. Eine Ermittlung der Objekte mit unterschiedlicher Reihenfolge wird fortgesetzt, bis alle nach Klassifizierung verbleibenden Objekte hinsichtlich ihrer Reihenfolge innerhalb der zu vergleichenden Sequenzen keine Reihenfolgedifferenz aufweisen. Abschließend wird eine reihenfolgerichtige Zuordnung zwischen im ersten Plan und im zweiten Plan erfassten korrespondierenden Objekten erstellt und an einer grafischen Benutzerschnittstelle dargestellt. Auf diese Weise können Inkonsistenzen zwischen den beiden Plänen hinsichtlich Reihenfolge, Vollständigkeit und Konnektivität dargestellt werden, um Handlungsanweisungen zur Behebung der Inkonsistenzen abzuleiten.

Entsprechend einer bevorzugten Ausgestaltung der vorliegenden Erfindung werden zusätzlich zu den ermittelten Hauptpfaden, die Hauptpfade erster Ordnung darstellen, zu diesen disjunkte Nebenpfade ermittelt. Innerhalb der Nebenpfade werden ggf. iterativ Hauptpfade zweiter bzw. höherer Ordnung ermittelt, die analog zu Hauptpfaden erster Ordnung behandelt werden. Eine derartige Behandlung der Hauptpfade zweiter bzw. höherer Ordnung umfasst insbesondere eine Ermittlung von jeweils miteinander zu vergleichenden Sequenzen von Objekten, eine Eliminierung von Objekten ohne gegenseitige Entsprechung und eine iterative Ermittlung und Eliminierung von Objekten innerhalb der zu vergleichenden Sequenzen mit unterschiedlicher Reihenfolge. Somit können auch Inkonsistenzen bei Nebenpfaden zuverlässig ermittelt werden.

Die Leitungskomponenten, Abzweige bzw. Anschlüsse umfassenden Objekte können beispielsweise anhand von Kennzeichen, Komponententyp, Nennweite bzw. Nennweitenkombination identifiziert werden. Darüber hinaus kann eine gegenseitige Entsprechung der Objekte aus den zu vergleichenden Sequenzen vorteilhafterweise anhand von Identifizierungen bzw. Kennzeichnungen der Objekte ermittelt werden. Dabei werden Objekte mit identischen oder zugeordneten Identifizierungen bzw. Kennzeichnungen miteinander verknüpft. Vorzugsweise werden innerhalb der zu vergleichenden Sequenzen nach Verknüpfung der Objekte mit identischen oder zugeordneten Identifizierungen bzw. Kennzeichnungen iterativ unter unverknüpften Objekten jeweils miteinander zu verknüpfende Objekte mit übereinstimmendem Objekttyp ermittelt, die hinsichtlich ihrer Reihenfolgedifferenz zueinander bzw. ihres Abstandes zu typgleichen Nachbarn innerhalb der zu vergleichenden Sequenzen ein minimales Unterscheidungsmaß aufweisen. Die ermittelten miteinander zu verknüpfenden Objekte werden als Objekte mit gegenseitiger Entsprechung behandelt. Insbesondere können jeweils miteinander zu verknüpfende Objekte mit übereinstimmendem Objekttyp ermittelt werden, die hinsichtlich ihrer Reihenfolgedifferenz zueinander und ihres gewichteten Abstandes zu typgleichen Nachbarn ersten und zweiten Grades innerhalb der zu vergleichenden Sequenzen ein minimales Unterscheidungsmaß aufweisen.

Entsprechend einer vorteilhaften Weiterbildung der vorliegenden Erfindung werden Objekte ohne gegenseitige Entsprechung, die in einem Hauptpfad des ersten oder zweiten Plans und in einem Nebenpfad des jeweils anderen Plans erfasst sind, als fremde Objekte klassifiziert, während Objekte ohne gegenseitige Entsprechung, die nur in einem der beiden Pläne erfasst sind, als fehlende Objekte klassifiziert werden. Außerdem werden Objekte mit unterschiedlicher Reihenfolge vorzugsweise als Objekte mit falscher Reihenfolge klassifiziert werden, während die nach Klassifizierung der Objekte mit unterschiedlicher Reihenfolge verbleibenden Objekte als reihenfolgerichtige Objekte klassifiziert werden. Eine Klassifizierung der Objekte kann beispielsweise an einer grafischen Benutzerschnittstelle als Ergebnis einer Konsistenzüberprüfung zwischen zweidimensional und dreidimensional erfassten Rohrleitungen dargestellt werden.

Das erfindungsgemäße Projektierungssystem ist zur Durchführung eines Verfahrens entsprechend vorangehenden Ausführungen vorgesehen und dafür ausgestaltet sowie eingerichtet, Rohrleitungen in einem ersten Plan zweidimensional und in einem in einem zweiten Plan dreidimensional zu erfassen. Außerdem ist das Projektierungssystem dafür ausgestaltet und eingerichtet, für in beiden Plänen erfasste Rohrleitungen jeweils zumindest ein Hauptpfad innerhalb des jeweiligen Plans zu ermitteln und für die erfassten Hauptpfade innerhalb beider Pläne jeweils miteinander zu vergleichende Sequenzen von Leitungskomponenten, Abzweigen bzw. Anschlüssen umfassenden Objekten zu ermitteln. Zusätzlich ist das Projektierungssystem dafür ausgestaltet und eingerichtet, aus den zu vergleichenden Sequenzen jeweils Objekte ohne gegenseitige Entsprechung zu eliminieren, die nur in einem der beiden Pläne bzw. nur in einem Hauptpfad eines der beiden Pläne erfasst sind.

Darüber hinaus ist das erfindungsgemäße Projektierungssystem dafür ausgestaltet und eingerichtet, nach Eliminierung der Objekte ohne gegenseitige Entsprechung innerhalb der zu vergleichenden Sequenzen iterativ Objekte mit unterschiedlicher Reihenfolge zu ermitteln und zu klassifizieren, die hinsichtlich ihrer Reihenfolge innerhalb der zu vergleichenden Sequenzen eine maximale Reihenfolgedifferenz aufweisen. Des Weiteren ist das Projektierungssystem dafür ausgestaltet und eingerichtet, eine Ermittlung der Objekte mit unterschiedlicher Reihenfolge fortzusetzen, bis alle nach Klassifizierung verbleibenden Objekte hinsichtlich ihrer Reihenfolge innerhalb der zu vergleichenden Sequenzen keine Reihenfolgedifferenz aufweisen, und abschließend eine reihenfolgerichtige Zuordnung zwischen im ersten Plan und im zweiten Plan erfassten korrespondierenden Objekten zu erstellen und an einer grafischen Benutzerschnittstelle darzustellen.

Das erfindungsgemäße Steuerungsprogramm ist in einen Arbeitsspeicher eines Rechners ladbar und weist zumindest einen Codeabschnitt auf, bei dessen Ausführung vorangehend beschriebene Schritte des erfindungsgemäßen Verfahrens ausgeführt werden, wenn das Steuerungsprogramm im Rechner abläuft.

Die vorliegende Erfindung wird nachfolgend an einem Ausführungsbeispiel anhand der Zeichnung näher erläutert. Es zeigt
- Figur 1: eine Darstellung eines ersten Plans mit zweidimensional erfassten Rohrleitungen und eines zugeordneten zweiten Plans mit dreidimensional erfassten Rohrleitungen,
- Figur 2: eine schematische Darstellung eines Verfahrensablaufs zur Ermittlung fremder und fehlender Objekte innerhalb miteinander zu vergleichender Pfade,
- Figur 3: eine schematische Darstellung eines Verfahrensablaufs zur anschließenden Ermittlung von Objekten mit falscher Reihenfolge und von reihenfolgerichtigen Objekten.

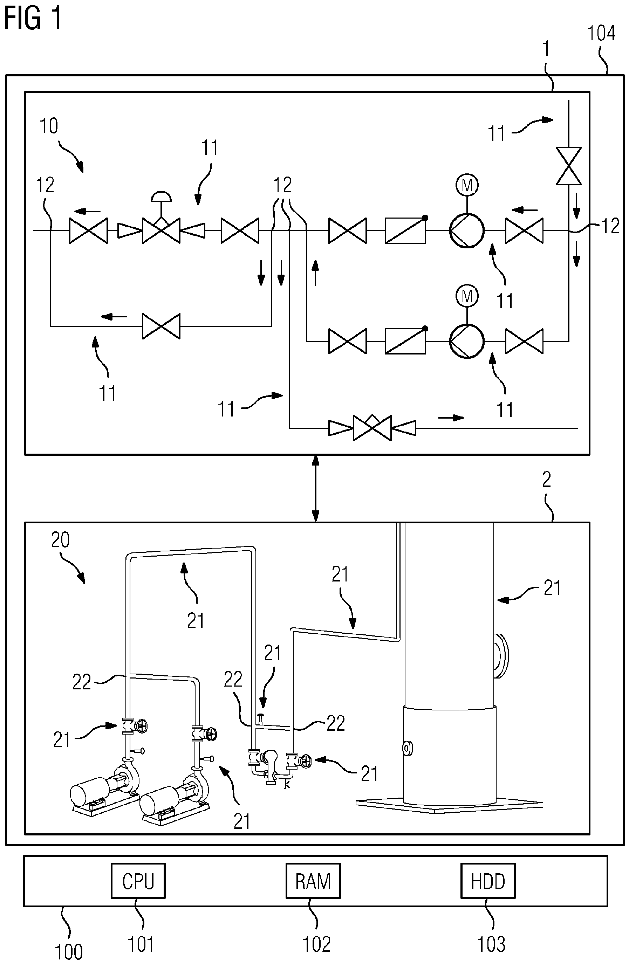

Entsprechend Figur 1 werden Rohrleitungen 10, 20 in einem rechnerbasierten Projektierungssystem, das zumindest einen Rechner 100 bzw. Computer und ein Steuerungsprogramm umfasst, in einem ersten Plan 1 zweidimensional und in einem zweiten Plan 2 dreidimensional erfasst. Das Steuerungsprogramm ist persistent in einem nichtflüchtigen Speicher 103 des Rechners 100 gespeichert und in dessen Arbeitsspeicher 102 ladbar und weist zumindest einen Codeabschnitt auf, bei dessen Verarbeitung durch einen Prozessor 101 des Rechners 100 nachfolgend beschriebene Schritte ausgeführt werden, wenn das Steuerungsprogramm im Rechner 100 abläuft.

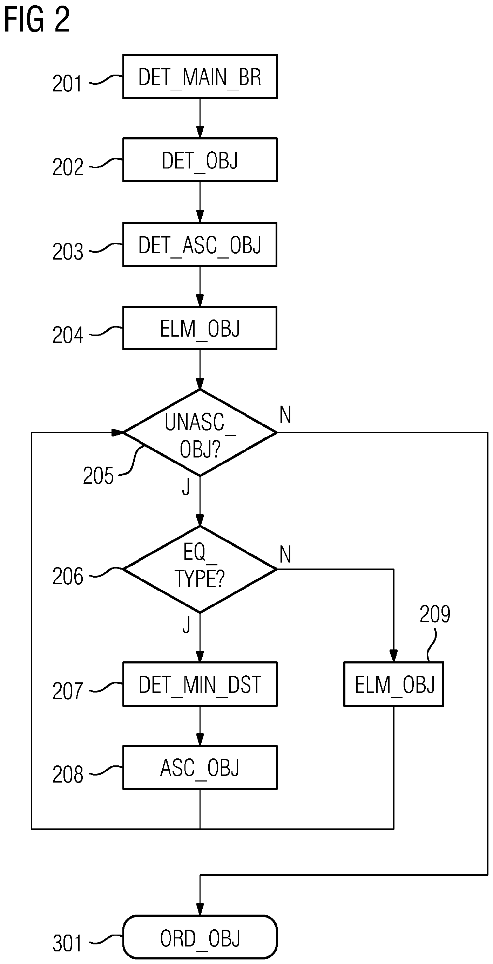

Für in beiden Plänen 1, 2 erfasste Rohrleitungen 10, 20 wird entsprechend Schritt 201 des in Figur 2 dargestellten Verfahrensablaufs jeweils zumindest ein Hauptpfad innerhalb des jeweiligen Plans 1, 2 ermittelt. Dabei wird der Hauptpfad als Pfad ermittelt, der keinen anderen Pfad innerhalb der jeweiligen Rohrleitung 10, 20 als Abzweigung bzw. Anschluss des anderen Pfades in Nebenfluss-Richtung trifft. Dabei weist jede Abzweigung 12, 22 genau einen eingehenden Anschluss in Hauptfluss-Richtung, genau einen ausgehenden Anschluss in Hauptfluss-Richtung und zumindest einen eingehenden oder ausgehenden Anschluss in Nebenfluss-Richtung auf. Grundsätzlich kann der Hauptpfad durch Eliminierung zu Maschen bzw. parallelen Zweigen innerhalb einer Rohrleitung 10, 20 führender Pfade ermittelt werden.

Darüber hinaus werden entsprechend Schritt 202 für die erfassten Hauptpfade innerhalb beider Pläne 1, 2 jeweils miteinander zu vergleichende Sequenzen von Leitungskomponenten 11, 21, Abzweigen 12, 22 bzw. Anschlüssen umfassenden Objekten ermittelt. Dabei werden die Leitungskomponenten 11, 21, Abzweige 12, 22 bzw. Anschlüsse umfassenden Objekte vorzugsweise anhand von Kennzeichen, Komponententyp, Nennweite bzw. Nennweitenkombination identifiziert. Anschließend wird in Schritt 203 eine gegenseitige Entsprechung der Objekte aus den zu vergleichenden Sequenzen anhand von Identifizierungen bzw. Kennzeichnungen der Objekte ermittelt. Objekte mit identischen oder zugeordneten Identifizierungen bzw. Kennzeichnungen werden miteinander verknüpft.

Aus den zu vergleichenden Sequenzen werden jeweils Objekte ohne gegenseitige Entsprechung eliminiert (Schritt 204), die nur in einem der beiden Pläne 1, 2 bzw. nur in einem Hauptpfad eines der beiden Pläne erfasst sind. Objekte ohne gegenseitige Entsprechung, die in einem Hauptpfad des ersten 1 oder zweiten Plans 2 und in einem Nebenpfad des jeweils anderen Plans erfasst sind, werden als fremde Objekte klassifiziert. Dagegen werden Objekte, die a priori keine gegenseitige Entsprechung aufweisen und nur in einem der beiden Pläne erfasst sind, als fehlende Objekte klassifiziert.

Nach Verknüpfung der Objekte mit identischen oder zugeordneten Identifizierungen bzw. Kennzeichnungen und Eliminierung der Objekte entsprechend Schritt 204 werden innerhalb der zu vergleichenden Sequenzen iterativ unter unverknüpften Objekten jeweils miteinander zu verknüpfende Objekte mit übereinstimmendem Objekttyp ermittelt, die hinsichtlich ihrer Reihenfolgedifferenz zueinander bzw. ihres Abstandes zu typgleichen Nachbarn innerhalb der zu vergleichenden Sequenzen ein minimales Abstands- bzw. Unterscheidungsmaß aufweisen. Hierzu wird entsprechend Schritt 205 überprüft, ob bislang unverknüpfte Objekte vorliegen. Falls unverknüpfte Objekte vorliegen, wird nachfolgend entsprechend Schritt 206 überprüft, ob zu einem ausgewählten Objekt zumindest ein typgleiches Objekt bzw. Objekt identischen Typs vorhanden ist. Ist zumindest ein typgleiches Objekt vorhanden, wird zum ausgewählten Objekt innerhalb der zu vergleichenden Sequenz das zu verknüpfende Objekt mit dem minimalen Abstands- bzw. Unterscheidungsmaß ermittelt (Schritt 207). Anschließend erfolgt eine Verknüpfung des ausgewählten Objekts mit dem ermittelten Objekt (Schritt 208) und ein Rücksprung zu Schritt 205. Die ermittelten miteinander zu verknüpfenden Objekte werden als Objekte mit gegenseitiger Entsprechung behandelt.

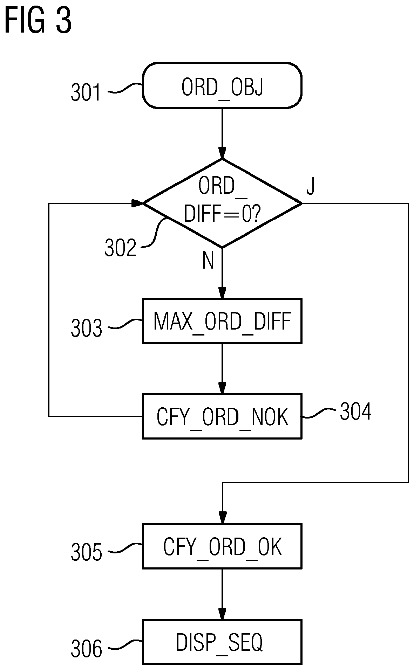

Wenn entsprechend Schritt 205 keine unverknüpften Objekte mehr vorliegen, erfolgt ein Übergang zu einer Ermittlung von reihenfolgerichtigen Objekten mit gegenseitiger Entsprechung innerhalb der zu vergleichenden Sequenzen (Schritt 301, siehe Figur 3). Falls zum ausgewählten Objekt entsprechend Schritt 206 kein typgleiches Objekt vorhanden ist, wird das ausgewählte Objekt entsprechend Schritt 209 eliminiert und als fehlendes Objekt klassifiziert. Anschließend erfolgt ein Rücksprung zu Schritt 205.

Vorzugsweise werden entsprechend den Schritten 205-208 jeweils miteinander zu verknüpfende Objekte mit übereinstimmendem Objekttyp ermittelt, die hinsichtlich ihrer Reihenfolgedifferenz zueinander und ihres gewichteten Abstandes zu typgleichen Nachbarn ersten und zweiten Grades innerhalb der zu vergleichenden Sequenzen ein minimales Abstands- bzw. Unterscheidungsmaß aufweisen. Als Gewichtungsfaktor für Nachbarn ersten Grades kann beispielsweise zwei verwendet werden, während der Gewichtungsfaktor für Nachbarn zweiten Grades auf eins gesetzt wird.

Nach Eliminierung der Objekte ohne gegenseitige Entsprechung innerhalb der zu vergleichenden Sequenzen werden entsprechend Figur 3 iterativ Objekte mit unterschiedlicher Reihenfolge ermittelt und klassifiziert, die hinsichtlich ihrer Reihenfolge innerhalb der zu vergleichenden Sequenzen eine maximale Reihenfolgedifferenz aufweisen. Eine Ermittlung der Objekte mit unterschiedlicher Reihenfolge wird fortgesetzt, bis alle nach Klassifizierung verbleibenden Objekte hinsichtlich ihrer Reihenfolge innerhalb der zu vergleichenden Sequenzen keine Reihenfolgedifferenz aufweisen. Hierzu wird nach Start der Ermittlung von reihenfolgerichtigen Objekten mit gegenseitiger Entsprechung (Schritt 301) entsprechend Schritt 302 überprüft, ob ausschließlich Objekte mit gegenseitiger Entsprechung vorliegen, die innerhalb der zu vergleichenden Sequenzen keine Reihenfolgedifferenz aufweisen. Liegen Objekte mit Reihenfolgedifferenz vor, werden entsprechend Schritt 303 die Objekte mit gegenseitiger Entsprechung ermittelt, die hinsichtlich ihrer Reihenfolge innerhalb der zu vergleichenden Sequenzen eine maximale Reihenfolgedifferenz aufweisen. Entsprechend Schritt 304 werden diese Objekte als Objekte mit falscher Reihenfolge klassifiziert. Anschließend erfolgt ein Rücksprung zu Schritt 302.

Liegen gemäß Überprüfung in Schritt 302 keine Objekte mit Reihenfolgedifferenz vor, werden die nach Klassifizierung der Objekte mit unterschiedlicher Reihenfolge verbleibenden Objekte als reihenfolgerichtige Objekte klassifiziert. Abschließend wird eine reihenfolgerichtige Zuordnung zwischen im ersten Plan und im zweiten Plan erfassten korrespondierenden Objekten erstellt (Schritt 305) und an einer grafischen Benutzerschnittstelle 104 des Rechners dargestellt (Schritt 306). Zusätzlich können auch die fremden Objekte, die fehlenden Objekt bzw. die Objekte mit falscher Reihenfolge mit ihrer jeweiligen Klassifizierung selektiv an der grafischen Benutzerschnittstelle 104 als Ergebnis einer Konsistenzüberprüfung zwischen zweidimensional und dreidimensional erfassten Rohrleitungen dargestellt werden.

Zusätzlich zu den ermittelten Hauptpfaden, die Hauptpfade erster Ordnung darstellen, werden zu diesen disjunkte Nebenpfade ermittelt. Innerhalb der Nebenpfade werden Hauptpfade zweiter bzw. höherer Ordnung ermittelt, die analog zu Hauptpfaden erster Ordnung behandelt werden. Insbesondere umfasst eine Behandlung der Hauptpfade zweiter bzw. höherer Ordnung eine Ermittlung von jeweils miteinander zu vergleichenden Sequenzen von Objekten, eine Eliminierung von Objekten ohne gegenseitige Entsprechung und eine iterative Ermittlung und Eliminierung von Objekten innerhalb der zu vergleichenden Sequenzen mit unterschiedlicher Reihenfolge.

## Patentansprüche

1. Verfahren zur Überprüfung einer konsistenten Erfassung von Rohrleitungen in einem Projektierungssystem, bei dem
- Rohrleitungen (10, 20) in einem ersten Plan (1) zweidimensional und in einem zweiten Plan (2) dreidimensional erfasst sind,
- für in beiden Plänen (1,2) erfasste Rohrleitungen (10, 20) jeweils zumindest ein Hauptpfad innerhalb des jeweiligen Plans ermittelt wird (201),
- für die erfassten Hauptpfade innerhalb beider Pläne (1, 2) jeweils miteinander zu vergleichende Sequenzen von Leitungskomponenten (11, 21), Abzweigen (12, 22) und/oder Anschlüssen umfassenden Objekten ermittelt werden (202),
- aus den zu vergleichenden Sequenzen jeweils Objekte ohne gegenseitige Entsprechung eliminiert werden, die nur in einem der beiden Pläne und/oder nur in einem Hauptpfad eines der beiden Pläne erfasst sind (204),
- nach Eliminierung der Objekte ohne gegenseitige Entsprechung innerhalb der zu vergleichenden Sequenzen iterativ Objekte mit unterschiedlicher Reihenfolge ermittelt und klassifiziert werden (301-304), die hinsichtlich ihrer Reihenfolge innerhalb der zu vergleichenden Sequenzen eine maximale Reihenfolgedifferenz aufweisen,
- eine Ermittlung der Objekte mit unterschiedlicher Reihenfolge fortgesetzt wird, bis alle nach Klassifizierung verbleibenden Objekte hinsichtlich ihrer Reihenfolge innerhalb der zu vergleichenden Sequenzen keine Reihenfolgedifferenz aufweisen,
- abschließend eine reihenfolgerichtige Zuordnung zwischen im ersten Plan und im zweiten Plan erfassten korrespondierenden Objekten erstellt (305) und an einer grafischen Benutzerschnittstelle dargestellt wird (306).

2. Verfahren nach Anspruch 1,
bei dem der Hauptpfad als Pfad ermittelt wird, der keinen anderen Pfad innerhalb der jeweiligen Rohrleitung (10, 20) als Abzweigung und/oder Anschluss des anderen Pfades in Nebenfluss-Richtung trifft, wobei jede Abzweigung (12, 22) genau einen eingehenden Anschluss in Hauptfluss-Richtung, genau einen ausgehenden Anschluss in Hauptfluss-Richtung und zumindest einen eingehenden oder ausgehenden Anschluss in Nebenfluss-Richtung aufweist.

3. Verfahren nach einem der Ansprüche 1 oder 2,
bei dem der Hauptpfad durch Eliminierung zu Maschen und/oder parallelen Zweigen innerhalb einer Rohrleitung führender Pfade ermittelt wird.

4. Verfahren nach einem der Ansprüche 1 bis 3,
bei dem die Leitungskomponenten (11, 21), Abzweige (12, 22) und/oder Anschlüsse umfassenden Objekte anhand von Kennzeichen, Komponententyp, Nennweite und/oder Nennweitenkombination identifiziert werden.

5. Verfahren nach Anspruch 4,
bei dem eine gegenseitige Entsprechung der Objekte aus den zu vergleichenden Sequenzen anhand von Identifizierungen und/oder Kennzeichnungen der Objekte ermittelt wird und bei dem Objekte mit identischen oder zugeordneten Identifizierungen und/oder Kennzeichnungen miteinander verknüpft werden (203).

6. Verfahren nach Anspruch 5,
bei dem innerhalb der zu vergleichenden Sequenzen nach Verknüpfung der Objekte mit identischen oder zugeordneten Identifizierungen und/oder Kennzeichnungen iterativ unter unverknüpften Objekten jeweils miteinander zu verknüpfende Objekte mit übereinstimmendem Objekttyp ermittelt werden (205-207), die hinsichtlich ihrer Reihenfolgedifferenz zueinander und/oder ihres Abstandes zu typgleichen Nachbarn innerhalb der zu vergleichenden Sequenzen ein minimales Unterscheidungsmaß aufweisen, und bei dem die ermittelten miteinander zu verknüpfenden Objekte als Objekte mit gegenseitiger Entsprechung behandelt werden (208).

7. Verfahren nach Anspruch 6,
bei dem jeweils miteinander zu verknüpfende Objekte mit übereinstimmendem Objekttyp ermittelt werden (205-207), die hinsichtlich ihrer Reihenfolgedifferenz zueinander und ihres gewichteten Abstandes zu typgleichen Nachbarn ersten und zweiten Grades innerhalb der zu vergleichenden Sequenzen ein minimales Unterscheidungsmaß aufweisen.

8. Verfahren nach einem der Ansprüche 1 bis 7,
bei dem Objekte ohne gegenseitige Entsprechung, die in einem Hauptpfad des ersten oder zweiten Plans und in einem Nebenpfad des jeweils anderen Plans erfasst sind, als fremde Objekte klassifiziert werden und bei dem Objekte ohne gegenseitige Entsprechung, die nur in einem der beiden Pläne erfasst sind, als fehlende Objekte klassifiziert werden.

9. Verfahren nach einem der Ansprüche 1 bis 8,
bei dem Objekte mit unterschiedlicher Reihenfolge als Objekte mit falscher Reihenfolge klassifiziert werden und bei dem die nach Klassifizierung der Objekte mit unterschiedlicher Reihenfolge verbleibenden Objekte als reihenfolgerichtige Objekte klassifiziert werden.

10. Verfahren nach einem der Ansprüche 8 oder 9,
bei dem eine Klassifizierung der Objekte an einer grafischen Benutzerschnittstelle als Ergebnis einer Konsistenzüberprüfung zwischen zweidimensional und dreidimensional erfassten Rohrleitungen dargestellt wird.

11. Verfahren nach einem der Ansprüche 1 bis 10,
bei dem zusätzlich zu den ermittelten Hauptpfaden, die Hauptpfade erster Ordnung darstellen, zu diesen disjunkte Nebenpfade ermittelt werden und bei dem innerhalb der Nebenpfade Hauptpfade zweiter und/oder höherer Ordnung ermittelt werden, die analog zu Hauptpfaden erster Ordnung behandelt werden.

12. Verfahren nach Anspruch 11,
bei dem eine Behandlung der Hauptpfade zweiter und/oder höherer Ordnung eine Ermittlung von jeweils miteinander zu vergleichenden Sequenzen von Objekten, eine Eliminierung von Objekten ohne gegenseitige Entsprechung und eine iterative Ermittlung und Eliminierung von Objekten innerhalb der zu vergleichenden Sequenzen mit unterschiedlicher Reihenfolge umfasst.

13. Projektierungssystem zur Durchführung eines Verfahrens nach einem der Ansprüche 1 bis 12, wobei das Projektierungssystem dafür ausgestaltet und eingerichtet ist,
- Rohrleitungen in einem ersten Plan zweidimensional und in einem zweiten Plan dreidimensional zu erfassen,
- für in beiden Plänen erfasste Rohrleitungen jeweils zumindest ein Hauptpfad innerhalb des jeweiligen Plans zu ermitteln,
- für die erfassten Hauptpfade innerhalb beider Pläne jeweils miteinander zu vergleichende Sequenzen von Leitungskomponenten, Abzweigen und/oder Anschlüssen umfassenden Objekten zu ermitteln,
- aus den zu vergleichenden Sequenzen jeweils Objekte ohne gegenseitige Entsprechung zu eliminieren, die nur in einem der beiden Pläne und/oder nur in einem Hauptpfad eines der beiden Pläne erfasst sind,
- nach Eliminierung der Objekte ohne gegenseitige Entsprechung innerhalb der zu vergleichenden Sequenzen iterativ Objekte mit unterschiedlicher Reihenfolge zu ermitteln und zu klassifizieren, die hinsichtlich ihrer Reihenfolge innerhalb der zu vergleichenden Sequenzen eine maximale Reihenfolgedifferenz aufweisen,
- eine Ermittlung der Objekte mit unterschiedlicher Reihenfolge fortzusetzen, bis alle nach Klassifizierung verbleibenden Objekte hinsichtlich ihrer Reihenfolge innerhalb der zu vergleichenden Sequenzen keine Reihenfolgedifferenz aufweisen,
- abschließend eine reihenfolgerichtige Zuordnung zwischen im ersten Plan und im zweiten Plan erfassten korrespondierenden Objekten zu erstellen und an einer grafischen Benutzerschnittstelle darzustellen.

14. Steuerungsprogramm, das in einen Arbeitsspeicher eines Rechners ladbar ist und zumindest einen Codeabschnitt aufweist, bei dessen Ausführung
- Rohrleitungen in einem ersten Plan zweidimensional und in einem zweiten Plan dreidimensional erfasst sind,
- für in beiden Plänen erfasste Rohrleitungen jeweils zumindest ein Hauptpfad innerhalb des jeweiligen Plans ermittelt wird,
- für die erfassten Hauptpfade innerhalb beider Pläne jeweils miteinander zu vergleichende Sequenzen von Leitungskompo-- nenten, Abzweigen und/oder Anschlüssen umfassenden Objekten ermittelt werden,
- aus den zu vergleichenden Sequenzen jeweils Objekte ohne gegenseitige Entsprechung eliminiert werden, die nur in einem der beiden Pläne und/oder nur in einem Hauptpfad eines der beiden Pläne erfasst sind,
- nach Eliminierung der Objekte ohne gegenseitige Entsprechung innerhalb der zu vergleichenden Sequenzen iterativ Objekte mit unterschiedlicher Reihenfolge ermittelt und klassifiziert werden, die hinsichtlich ihrer Reihenfolge innerhalb der zu vergleichenden Sequenzen eine maximale Reihenfolgedifferenz aufweisen,
- eine Ermittlung der Objekte mit unterschiedlicher Reihenfolge fortgesetzt wird, bis alle nach Klassifizierung verbleibenden Objekte hinsichtlich ihrer Reihenfolge innerhalb der zu vergleichenden Sequenzen keine Reihenfolgedifferenz aufweisen,
- abschließend eine reihenfolgerichtige Zuordnung zwischen im ersten Plan und im zweiten Plan erfassten korrespondierenden Objekten erstellt und an einer grafischen Benutzerschnittstelle dargestellt wird,
wenn das Steuerungsprogramm im Rechner abläuft.

## Claims

1. Method for checking the consistent recording of pipelines in a project planning system, in which
- pipelines (10, 20) are recorded two-dimensionally in a first plan (1) and three-dimensionally in a second plan (2),
- at least one main path within each plan is determined (201) for each of the pipelines (10, 20) recorded in both plans (1, 2),
- for the main paths recorded within both plans (1, 2), sequences of objects comprising line components (11, 21), branches (12, 22) and/or connections are determined (202), which are each to be compared with one another,
- from the sequences to be compared, objects without mutual correspondence that are only recorded in one of the two plans and/or only in one main path of one of the two plans are each eliminated (204),
- after elimination of the objects without mutual correspondence, within the sequences to be compared, objects with different ordering are iteratively determined and classified (301-304), which have a maximum order difference with respect to their ordering within the sequences to be compared,
- determination of the objects with different ordering is continued until all objects remaining after classification have no order difference with respect to their ordering within the sequences to be compared,
- finally, a correctly ordered assignment is created (305) between corresponding objects recorded in the first plan and in the second plan, and displayed (306) on a graphical user interface.

2. Method according to Claim 1,
in which the main path is determined as a path that does not meet any other path within the respective pipeline (10, 20) as a branch and/or connection of the other path in the tributary direction, wherein each branch (12, 22) has exactly one incoming connection in the main flow direction, exactly one outgoing connection in the main flow direction, and at least one incoming or outgoing connection in the tributary direction.

3. Method according to either of Claims 1 or 2,
in which the main path is determined by eliminating paths leading to loops and/or parallel branches within a pipeline.

4. Method according to any one of Claims 1 to 3,
in which the objects comprising line components (11, 21), branches (12, 22) and/or connections are identified by means of markings, component type, nominal diameter and/or nominal diameter combination.

5. Method according to Claim 4,
in which a mutual correspondence of the objects from the sequences to be compared is determined by means of identifications and/or markings of the objects and in which objects with identical or assigned identifications and/or markings are linked together (203).

6. Method according to Claim 5,
in which, within the sequences to be compared, after linking of the objects with identical or assigned identifications and/or markings, among unlinked objects, respective objects with matching object type that are to be linked to one another are determined (205-207) iteratively, which have a minimum difference measure with respect to their order difference to one another and/or their distance from neighbors of the same type within the sequences to be compared, and in which the determined objects to be linked to one another are treated as objects with mutual correspondence (208).

7. Method according to Claim 6,
in which respective objects with matching object type that are to be linked to one another are determined (205-207), which have a minimum difference measure with respect to their order difference to one another and their weighted distance from first- and second-degree neighbors of the same type within the sequences to be compared.

8. Method according to any one of Claims 1 to 7,
in which objects without mutual correspondence which are recorded in a main path of the first or second plan and in a secondary path of the respective other plan are classified as foreign objects, and in which objects without mutual correspondence which are recorded in only one of the two plans are classified as missing objects.

9. Method according to any one of Claims 1 to 8,
in which objects with different ordering are classified as incorrectly ordered objects and in which the objects remaining after classification of the objects with different ordering are classified as correctly ordered objects.

10. Method according to either of Claims 8 or 9,
in which a classification of the objects is displayed on a graphical user interface as the result of a consistency check between two-dimensionally and three-dimensionally recorded pipelines.

11. Method according to any one of Claims 1 to 10,
in which in addition to the determined main paths, which represent first-order main paths, secondary paths that are disjunct to these are determined and in which second-order and/or higher-order main paths, which are treated in the same way as first-order main paths, are determined within the secondary paths.

12. Method according to Claim 11,
in which a treatment of the second- and/or higher-order main paths comprises a determination of sequences of objects that are each to be compared with one another, an elimination of objects without mutual correspondence, and an iterative determination and elimination of objects with different ordering within the sequences to be compared.

13. Project planning system for carrying out a method according to any one of Claims 1 to 12, the project planning system being designed and configured
- to record pipelines two-dimensionally in a first plan and three-dimensionally in a second plan,
- to determine at least one main path within each plan for each of the pipelines recorded in both plans,
- for the main paths recorded within both plans, to determine sequences of objects comprising line components, branches and/or connections, which are each to be compared with one another,
- from the sequences to be compared, to eliminate objects without mutual correspondence that are only recorded in one of the two plans and/or only in one main path of one of the two plans,
- after elimination of the objects without mutual correspondence, within the sequences to be compared, to iteratively determine and classify objects with different ordering, which have a maximum order difference with respect to their ordering within the sequences to be compared,
- to continue determination of the objects with different ordering until all objects remaining after classification have no order difference with respect to their ordering within the sequences to be compared,
- finally, to create a correctly ordered assignment between corresponding objects recorded in the first plan and in the second plan, and display it on a graphical user interface.

14. Control program that can be loaded into a working memory of a computer and comprises at least one code section, upon the execution of which
- pipelines are recorded two-dimensionally in a first plan and three-dimensionally in a second plan,
- for pipelines recorded in both plans, at least one main path is determined within each plan,
- for the main paths recorded within both plans, sequences of objects comprising line components, branches and/or connections are determined, which are each to be compared with one another,
- from the sequences to be compared, objects without mutual correspondence that are only recorded in one of the two plans and/or only in one main path of one of the two plans are each eliminated,
- after elimination of the objects without mutual correspondence, within the sequences to be compared, objects with different ordering are iteratively determined and classified, which have a maximum order difference with respect to their ordering within the sequences to be compared,
- determination of the objects with different ordering is continued until all objects remaining after classification have no order difference with respect to their ordering within the sequences to be compared,
- finally, a correctly ordered assignment is created between corresponding objects recorded in the first plan and in the second plan, and displayed on a graphical user interface, when the control program is running on the computer.

## Revendications

1. Procédé de contrôle de la cohérence d'un relevé de tuyauteries dans un système de planification, dans lequel
- on relève des tuyauteries (10, 20) en deux dimensions dans un premier plan (1) et en trois dimensions dans un deuxième plan (2),
- pour les tuyauteries (10, 20) relevées dans les deux plans (1, 2), on détermine (201) respectivement un chemin principal au sein du plan respectif,
- pour les chemins principaux relevés, on détermine (202) dans les deux plans (1, 2) respectivement des séquences, à comparer l'une à l'autre, d'objets comprenant des composants (11, 21) de tuyaux, des dérivations (12, 22) et/ou des raccords,
- à partir des séquences à comparer, on élimine respectivement des objets sans correspondance mutuelle, qui sont relevés (204) seulement dans l'un des deux plans et/ou seulement dans un chemin principal de l'un des deux plans,
- après élimination des objets sans correspondance mutuelle dans les séquences à comparer, on détermine et on classe (301à 304) par itération des objets ayant un ordre différent qui ont, du point de vue de leur ordre, dans les séquences à comparer, une différence d'ordre maximum,
- on poursuit une détermination des objets ayant un ordre différent, jusqu'à ce que tous les objets, restant après le classement n'aient, en ce qui concerne leur ordre dans les séquences à comparer, pas de différence d'ordre,
- enfin, on établit (305) une association justifiée en ordre entre des objets correspondants relevés dans le premier plan et le deuxième plan et on la représente (306) sur une interface graphique d'utilisateur.

2. Procédé suivant la revendication 1,
dans lequel on détermine le chemin principal, comme chemin qui ne rencontre pas d'autre chemin dans la tuyauterie (10, 20) respective comme dérivation et/ou raccord de l'autre chemin dans une direction de flux secondaire, chaque dérivation (12, 22) ayant exactement un raccord entrant dans la direction du flux principal, exactement un raccord sortant dans la direction du flux principal et au moins un raccord entrant ou sortant dans la direction du flux secondaire.

3. Procédé suivant l'une des revendications 1 ou 2,
dans lequel on détermine le chemin principal en éliminant des chemins menant dans un tuyau à des mailles et/ou à des branches parallèles.

4. Procédé suivant l'une des revendications 1 à 3,
dans lequel on identifie des objets, comprenant des composants (11, 21) de conduit, des dérivations (12, 22) et/ou des raccords, à l'aide de caractéristiques, de type de composant, de largeur nominale et/ou de combinaison de largeur nominale.

5. Procédé suivant la revendication 4,
dans lequel on détermine, à l'aide d'identifications et/ou de caractérisations des objets, une correspondance mutuelle des objets à partir des séquences à comparer, et dans lequel on combine (203) entre eux des objets ayant des identifications et/ou des caractérisations identiques ou associées.

6. Procédé suivant la revendication 5,
dans lequel, dans les séquences à comparer, après combinaison des objets ayant des identifications et/ou des caractérisations identiques ou associées, on détermine (205 à 207), par itération, parmi des objets non combinés respectivement des objets à combiner entre eux ayant un type d'objet en coïncidence qui, en ce qui concerne leur différence d'ordre, ont l'un par rapport à l'autre et/ou leur distance à des voisins de même type dans les séquences à comparer, une mesure de différence minimum et dans lequel on traite (208) les objets déterminés à combiner entre eux comme objets ayant une correspondance mutuelle.

7. Procédé suivant la revendication 6,
dans lequel on détermine (205 à 207) des objets à combiner entre eux respectivement ayant un type d'objet, qui coïncide, qui ont, en ce qui concerne leur différence d'ordre l'un par rapport à l'autre et leur distance pondérée à des voisins de même type d'un premier et d'un deuxième degré dans la séquence à comparer, une mesure de différence minimum.

8. Procédé suivant l'une des revendications 1 à 7,
dans lequel on classe des objets sans correspondance mutuelle, qui sont relevés dans un chemin principal du premier ou du deuxième plan et dans un chemin secondaire de respectivement l'autre plan, comme des objets étrangers et dans lequel on classe, comme objets manquants, des objets sans correspondance mutuelle, qui sont relevés seulement dans l'un des deux plans.

9. Procédé suivant l'une des revendications 1 à 8,
dans lequel on classe des objets d'ordre différent, comme objets d'ordre faux, et dans lequel on classe, comme objets justifiés en ordre, les objets restant après classement des objets ayant un ordre différent.

10. Procédé suivant l'une des revendications 8 ou 9,
dans lequel on représente un classement des objets sur une interface graphique d'utilisateur, comme résultat d'un contrôle de cohérence entre des tuyaux relevés en deux dimensions et en trois dimensions.

11. Procédé suivant l'une des revendications 1 à 10,
dans lequel, en plus des chemins principaux déterminés, qui représentent des chemins principaux du premier ordre, on détermine des chemins secondaires disjoints de ceux-ci et dans lequel, dans les chemins secondaires, on détermine des chemins principaux de deuxième ordre et/ou d'ordre plus élevé que l'on traite de manière analogue à des chemins principaux du premier ordre.

12. Procédé suivant la revendication 11,
dans lequel un traitement des chemins principaux du deuxième ordre et/ou d'un ordre plus élevé comprend une détermination de séquences, à comparer entre elles, d'objets, une élimination d'objets sans correspondance mutuelle et une détermination et une élimination, par itération, d'objets dans les séquences à comparer ayant un ordre différent.

13. Système de planification pour effectuer un procédé suivant l'une des revendications 1 à 12, dans lequel le système de planification est conformé et conçu pour
- relever des tuyauteries en deux dimensions dans un premier plan et en trois dimensions dans un deuxième plan,
- déterminer, pour les tuyauteries relevées dans les deux plans, respectivement au moins un chemin principal dans le plan respectif,
- pour les chemins principaux relevés dans les deux plans, déterminer respectivement des séquences à comparer entre elles d'objets, comprenant des composants de conduit, des dérivations et/ou des raccords,
- à partir des séquences à comparer, éliminer des objets respectivement sans correspondance mutuelle, qui sont relevés seulement dans l'un des deux plans et/ou seulement dans un chemin principal de l'un des deux plans,
- après élimination des objets sans correspondance mutuelle dans les séquences à comparer, déterminer et classer par itération des objets ayant un ordre différent, qui, en ce qui concerne leur ordre dans les séquences à comparer, ont une différence d'ordre maximum,
- continuer une détermination des objets ayant un ordre différent, jusqu'à ce que tous les objets restants après le classement, n'aient pas, en ce qui concerne leur ordre dans les séquences à comparer, de différence d'ordre,
- enfin, établir une association justifiée en ordre entre des objets correspondants relevés dans le premier plan et dans le deuxième plan et la représenter sur une interface graphique d'utilisateur.

14. Programme de commande, qui peut être chargé dans une mémoire de travail d'un ordinateur et qui a au moins une partie de code, à la réalisation duquel
- on relève des tuyauteries en deux dimensions dans un premier plan et en trois dimensions dans un deuxième plan,
- pour les tuyauteries relevées dans les deux plans, on détermine respectivement un chemin principal au sein du plan respectif,
- pour les chemins principaux relevés, on détermine dans les deux plans respectivement des séquences, à comparer l'une à l'autre, d'objets comprenant des composants de tuyau, des dérivations et/ou des raccords,
- à partir des séquences à comparer, on élimine respectivement des objets sans correspondance mutuelle, qui sont relevés seulement dans l'un des deux plans et/ou seulement dans un chemin principal de l'un des deux plans,
- après élimination des objets sans correspondance mutuelle dans les séquences à comparer, on détermine et on classe par itération des objets ayant un ordre différent, qui ont, du point de vue de leur ordre, dans les séquences à comparer, une différence d'ordre maximum,
- on poursuit une détermination des objets ayant un ordre différent, jusqu'à ce que tous les objets, restant après le classement n'aient, en ce qui concerne leur ordre dans les séquences à comparer, pas de différence d'ordre,
- enfin, on établit une association justifiée en ordre entre des objets correspondants relevés dans le premier plan et le deuxième plan et on la représente sur une interface graphique d'utilisateur
lorsque le programme de commande se déroule dans l'ordinateur.
